(19)

Europäisches
Patentamt
European
Patent Office
Office européen
des brevets

(11)     **EP 1 622 160 B1**

(12)                    **EUROPEAN PATENT SPECIFICATION**

(45) Date of publication and mention
of the grant of the patent:
**10.09.2008   Bulletin 2008/37**

(51) Int Cl.:
**G11C 11/16** (2006.01)

(21) Application number: **05254637.1**

(22) Date of filing: **26.07.2005**

(54) **Magnetic film structure using spin charge, method of manufacturing the same, semiconductor device having the same, and method of operating the semiconductor device**

Magnetfilmstruktur mit Spinladung, Verfahren zu deren Herstellung, Halbleitervorrichtung mit einer derartigen Struktur und Verfahren zum Betrieb der Halbleitervorrichtung

Structure de film magnétique à charge de spin, procédé de sa fabrication, dispositif semiconducteur comprenant ladite structure, et mode de fonctionnement du dispositif semiconducteur

(84) Designated Contracting States:
**DE FR GB**

(30) Priority: **31.07.2004   KR 2004060719**

(43) Date of publication of application:
**01.02.2006   Bulletin 2006/05**

(73) Proprietor: **SAMSUNG ELECTRONICS CO., LTD.
Suwon-si,
Gyeonggi-do (KR)**

(72) Inventors:
• **Kim, Tae-wan
Yongin-si
Gyeonggi-do (KR)**
• **Park, Wan-jun
Seoul (KR)**
• **Park, Sang-jin
Pyeongtaek-si
Gyeonggi-do (KR)**
• **Hwang, In-jun,
Samsung Adv. Inst. of Technology
Yongin-si
Gyeonggi-do (KR)**

• **Kwon, Soon-ju
Pohang Univ. of Science & Technology
Nam-gu
Pohang-si
Gyeongsangbuk-do (KR)**
• **Kim, Young-keun
Gangnam-gu
Seoul (KR)**
• **Gambino, Richard J.,
Stony Brook University
Stony Brook, NY 11764-2275 (US)**

(74) Representative: **Greene, Simon Kenneth
Elkington and Fife LLP
Prospect House
8 Pembroke Road
Sevenoaks,
Kent TN13 1XR (GB)**

(56) References cited:
• **TEHRANI ET AL: "Magnetoresistive Random Access Memory Using Magnetic Tunnel Junctions" PROCEEDINGS OF THE IEEE, vol. 91, no. 5, May 2003 (2003-05), pages 703-714, XP002381625**

**EP 1 622 160 B1**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a method of operating a semiconductor memory device.

The integration degree of semiconductor devices has rapidly increased as semiconductor technologies have been developed.

An ideal semiconductor device has a high integration degree and low power consumption, operates at a high-speed operation, and is nonvolatile.

A conventional semiconductor device has high power consumption and thereby generates much heat. To solve this drawback, a superconductor can be used, but this is applicable only in a limited field.

As the semiconductor device generates heat, the operation speed thereof rapidly decreases.

Meanwhile, in connection with the nonvolatility of semiconductor devices, a flash memory has been widely used. In addition, as an MRAM or a SONOS memory is introduced, the nonvolatility of a semiconductor device is improved.

However, the characteristics of the conventional semiconductor device are still far from those of the ideal semiconductor device.

Accordingly, a semiconductor device having better characteristics is required and in this regard, a semiconductor device using an electron spin is noted.

An MRAM is described in Tehrani et al, "Magnetoresistive random access memory using magnetic tunnel junctions", Processsings of the IEEE, vol 91, No. 5, May 2003, pages 703 to 714. The use of Heusler alloys is suggested.

According to the present invention, there is provided a method of operating a semiconductor memory device, the semiconductor memory device having: a substrate; a switching element formed on the substrate; and a data storing unit connected to the switching element, the data storing unit having a lower magnetic film, a tunneling film and an upper magnetic film that are sequentially deposited, the lower and upper magnetic films being ferromagnetic films forming an electrochemical potential difference therebetween when the lower and upper magnetic films have opposite magnetization directions, wherein in a state where the switching element is turned off, a magnetic field is applied to the data storing unit in a given direction to write data in the data storing unit.

After writing the data in the data storing unit, in a state where the switching element is turned on, an offset voltage of the data storing unit is measured to read data from the data storing unit.

Data recorded in the data storing unit may be read by a first process of applying the magnetic field to the data storing unit such that the upper and lower magnetic films have the same magnetization direction in the state where the switching element is turned on, and a second process of sensing whether or not a current of more than a predetermined value flows through the data storing unit.

In case where the current of more than the predetermined value is sensed, a magnetization state of one of the upper and lower magnetic films whose magnetization state is varied through the first process may be restored to the original state.

At this time, a magnetic field having an opposite direction to the magnetic field applied in the first process may be applied to the magnetic film whose magnetization state is varied through the first process to restore magnetization state of the magnetic film to the original state.

In the state where the switching element is turned off, the upper and lower magnetic films may be allowed to have the same magnetization direction to erase data from the data storing unit.

Since the present invention can reduce a device driving voltage to about several millivolts, a power consumption can be reduced, and a generated amount of heat depending on the power consumption can be reduced too. Therefore, a device operation speed can be also increased. Further, since the magnetic film structure has very small size, an integration degree of a device employing the same can be increased. Furthermore, since the magnetic film structure can have its own potential difference, the magnetic film structure can be integrated to embody a new battery.

The above and other features and advantages of the present invention will become more apparent by describing in detail exemplary embodiments thereof with reference to the attached drawings in which:

FIG. 1 is a sectional view illustrating a magnetic film structure according to a preferred embodiment of the present invention;

FIG. 2 is a graph illustrating a resistance variation of a magnetic film structure when a bias voltage applied to the magnetic film structure of FIG. 1 varies from -0.6V to +0.6V;

FIG. 3 is a graph illustrating a resistance variation of the magnetic film structure of FIG. 1 at a bias voltage (-0.2mV to +0.3mV) at which a resistance and a magneto-resistance ratio are asymmetric;

FIG. 4 is a graph illustrating a resistance variation depending on a magnetic field of the magnetic film structure of FIG. 1 at a first point (P1) of FIG. 3;

FIG. 5 is a graph illustrating a resistance variation depending on a magnetic field of the magnetic film structure of FIG. 1 at a second point (P2) of FIG. 3;

FIG. 6 is a graph illustrating a resistance variation depending on a magnetic field of the magnetic film structure of FIG. 1 at a third point (P3) of FIG. 3;

FIG. 7 is a graph illustrating a resistance variation depending on a magnetic field of the magnetic film structure of FIG. 1 at a fourth point (P4) of FIG. 3;

FIG. 8 is a graph illustrating a resistance variation of the magnetic film structure of FIG. 1 depending on a magnetic field when a plurality of bias voltages is respectively applied;

FIG. 9 is a graph illustrating a resistance variation of the magnetic film structure of FIG. 1 depending on a magnetic field at a bias voltage of 55mV;

FIGS. 10 and 11 are sectional views respectively illustrating a method of applying a bias voltage to the magnetic film structure of FIG. 1;

FIG. 12 is a graph illustrating a current-voltage characteristic of the magnetic film structure of FIG. 1 to which a bias voltage is applied as shown in FIG. 10;

FIG. 13 is a graph illustrating a current-voltage characteristic of the magnetic film structure of FIG. 1 to which a bias voltage is applied as shown in FIG. 11;

FIG. 14 is a view illustrating a curve of a current-voltage characteristic of the magnetic film structure of FIG. 1 having a lower magnetic film (half-metal ferromagnetic layer) that is formed under a second condition (20mTorr, 600°C) and having a size of $10\mu m \times 10\mu m$;

FIG. 15 is a view illustrating a curve of a current-voltage characteristic of the magnetic film structure of FIG. 1 having a lower magnetic film (half-metal ferromagnetic layer) that is formed under a second condition (20mTorr, 600°C) and having a size of $30\mu m \times 30\mu m$;

FIG. 16 is a view illustrating a curve of a current-voltage characteristic of the magnetic film structure of FIG. 1 having a lower magnetic film (half-metal ferromagnetic layer) that is formed under a second condition (20mTorr, 600°C) and having a size of $50\mu m \times 50\mu m$;

FIG. 17 is a view illustrating a curve of a current-voltage characteristic of the magnetic film structure of FIG. 1 having a lower magnetic film (half-metal ferromagnetic layer) that is formed under a second condition (20mTorr, 600°C) and having a size of $100\mu m \times 100\mu m$;

FIG. 18 is a view illustrating a curve of a current-voltage characteristic of the magnetic film structure of FIG. 1 to which a resistor is connected;

FIG. 19 is a graph illustrating a variation of an offset voltage depending on the variation of an absolute temperature in a magnetic film structure of FIG. 1;

FIG. 20 is a sectional view illustrating the magnetic film structure of FIG. 1 with a lower magnetic film and an upper magnetic film being reversed;

FIGS. 21 and 22 are simple sectional views illustrating a method of manufacturing the magnetic film structure of FIG. 1;

FIG. 23 is a Transmission Electron Microscopy (TEM) illustrating a uniform thickness of a tunneling film of the magnetic film structure of FIG. 1 formed through the manufacturing method shown in FIGS. 21 and 22;

FIG. 24 is a sectional view illustrating a magnetic RAM according to the present invention in which the magnetic film structure of FIG. 20 is used as a Magnetic Tunnel Junction (MTJ) layer;

FIG. 25 is a sectional view illustrating a MTJ layer in which magnetic films have the same magnetization direction on and under a tunneling film in the magnetic RAM of FIG. 24;

FIG. 26 is a sectional view illustrating a MTJ layer in which magnetic films have opposite magnetization directions to each other on and under a tunneling film in the magnetic RAM of FIG. 25; and

FIG. 27 is a sectional view illustrating an example of the magnetic film structure of FIG. 1 used as a magnetic sensor.

The present invention will now be described more fully with reference to the accompanying drawings, in which exemplary embodiments of the present invention are shown. The present invention may, however, be embodied in many different forms and should not be construed as being limited to the embodiments set forth herein; rather, these embodiments are provided so that this disclosure will be thorough and complete, and will fully convey the concept of the invention to those skilled in the art. In the drawings, the thicknesses of layers and regions are exaggerated for clarity.

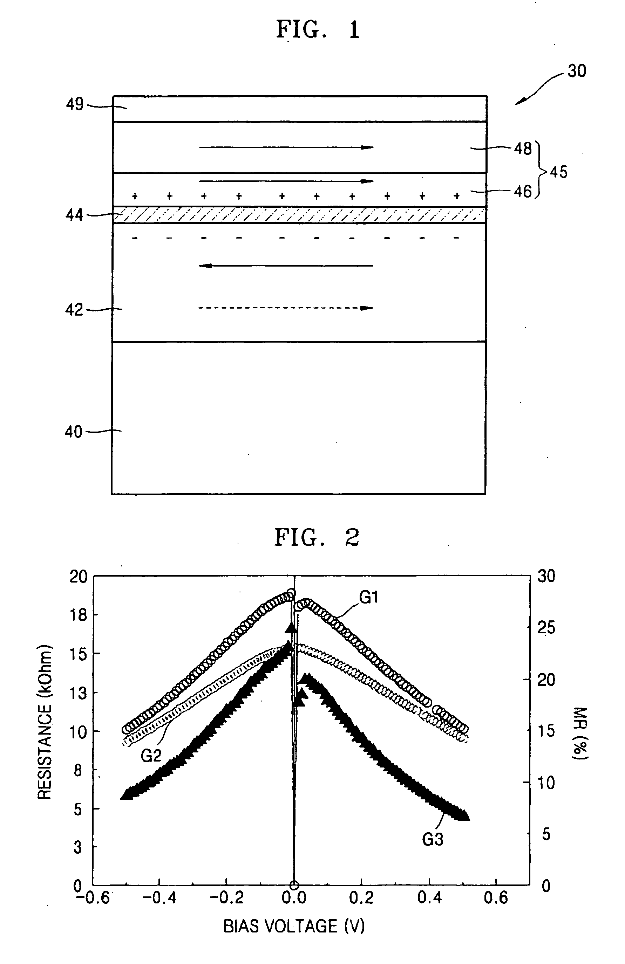

FIG. 1 is a sectional view illustrating a magnetic film structure used in a preferred embodiment of the present invention.

First, the magnetic film structure having a spin charge, which is caused by an electrochemical potential difference of an electron spin state, is described.

The magnetic film structure 30 of FIG. 1 has vertical and horizontal lengths of about $10\mu m$. The magnetic film structure 30 may have a larger or smaller vertical and horizontal length than $10\mu m$. The magnetic film structure 30 includes a lower magnetic film 42, a tunneling film 44, and an upper magnetic film 45. A seed layer 40 may be provided under the lower magnetic film 42, and a protection capping layer 49 may be provided on the upper magnetic film 45.

The lower magnetic film 42 is formed under a first condition (20mTorr, 500°C) and has a first electron spin state density. The lower magnetic film 42 may be a Heusler alloy or a half-metal ferromagnetic layer such as a $Co_2MnSi$ layer, all electrons of which may be spin-polarized in a predetermined direction when an external magnetic field is applied. However, the lower magnetic film 42 may be formed of other ferromagnetic layers equivalent to the Heusler alloy or a half-metal ferromagnetic layer. When the lower magnetic film 42 is the $Co_2MnSi$ layer, it may have a thickness of about 47nm, but mat have a larger or smaller thickness than 47nm. When the lower magnetic film 42 is a different half-metal ferromagnetic layer, the lower magnetic film 42 may have a thickness of 47nm or a different thickness. A solid-line arrow illustrated in the lower magnetic film 42 denotes a magnetization direction, that is, a spin polarization direction, which is caused by the external magnetic field, of the lower magnetic film 42. Additionally, a dotted-line arrow denotes the magnetisation direction of the lower magnetic film 42 when the external magnetic field has an opposite direction. The tunneling film 44 may have a predetermined thickness through which electrons can be tunneled. For example, the tunneling film 44 may be an aluminum oxide layer (AI0x). At this time, the tunneling film 44 may have a thickness of about 2nm. The tunneling film 44 may be an insulating layer, not an oxide layer. At this time, the tunneling film 44 may have a different thickness from the oxide layer. The upper magnetic film 45 may comprise first and second ferromagnetic layer 46 and 48 deposited sequentially. The first ferromagnetic film 46 is a pinned layer having a second electron spin state density in which the magnetization direction or the spin polarization direction of the electrons is fixed in a given direction. In the first ferromagnetic film 46, the electrons are spin-polarized in the predetermined direction in the same manner as the lower magnetic film 42. However, all the spin polarizations of the electrons of the first ferromagnetic film 46 do not have the same direction unlike those of the lower magnetic film 42. In other words, most of electrons of the first ferromagnetic film 46 are spin-polarized in the predetermined direction, but some electrons are spin-polarized in an opposite direction to the predetermined direction. The externally shown magnetization direction of the first ferromagnetic film 46 is a spin polarization direction, which most of electrons of the first ferromagnetic film 46 have. The arrow shown in the first ferromagnetic film 46 denotes the magnetization direction of the first ferromagnetic film 46. This arrow denotes the spin polarization of the most of the electrons of the first ferromagnetic film 46. Accordingly, it is shown that the first ferromagnetic film 46 is magnetized in the arrow direction shown in the drawings, but a minority of the electrons of the first ferromagnetic film 46 has an opposite magnetization direction to the arrow shown in the first ferromagnetic film 46. The first ferromagnetic film 46 may be a cobalt iron (CoFe) layer. The second ferromagnetic film 48 is an antiferromagnetic layer, which is a pinning layer for pinning the magnetization direction of the first ferromagnetic film 46. The second ferromagnetic film 48 may be an iridium manganese (IrMn) layer of a predetermined thickness, for example. The first ferromagnetic film 46 is pinned by the second ferromagnetic layer 48 through exchange coupling. Accordingly, the first and second ferromagnetic films 46 and 48 have the same magnetization direction. When the first ferromagnetic film 46 is the IrMn layer, it may have a thickness of 15.5nm. However, when the first ferromagnetic film 46 is a different layer, it may have a different thickness. The capping layer 49 prevents the second ferromagnetic film 48 from being oxidized, and may be formed of ruthenium (Ru) to have a thickness of 60nm. The seed layer 40 provided under the lower magnetic film 42 allows the growth of the lower magnetic film 42, and may comprise a tantalum (Ta) layer and a ruthenium (Ru) layer sequentially deposited. The tantalum layer has a thickness of about 42nm, and the ruthenium layer has a thickness of about 9.5nm.

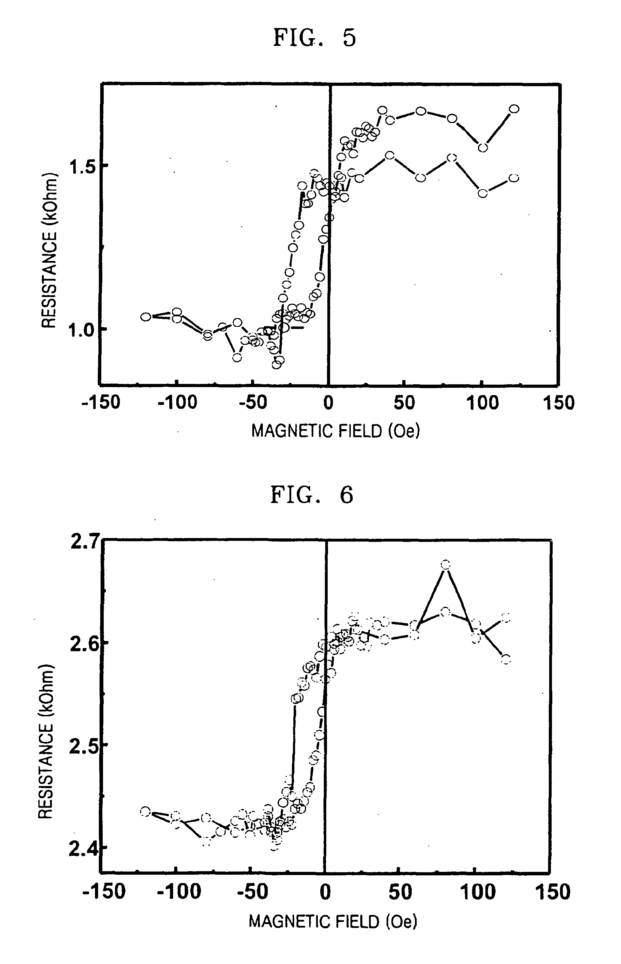

When the tunneling film 44 is interposed between and contacts the lower magnetic film 42 and the first ferromagnetic film 46 in a state where they have a different electron spin state density, the electrochemical potential difference is generated between the lower magnetic film 42 and the first ferromagnetic film 46. As shown in FIG. 5, the electrochemical potential difference causes the electrons, which are in a spin down state, of the first ferromagnetic film 46 to pass through the tunneling film 44 and move to the lower magnetic film 42. At this time, the electrons of the first ferromagnetic film 46 are changed in a spin up state. As a result, the electrons are moved from the first ferromagnetic film 46 to the lower magnetic film 42 to store a negative charge (-) in an interface of the lower magnetic film 42 contacting with the tunneling film 44, and store a positive charge (+) in an interface of the first ferromagnetic film 46 contacting with the tunneling film 44. Accordingly, the potential difference is generated between the lower magnetic film 42 and the first ferromagnetic film 46. A predetermined offset voltage may be applied from the outside of the magnetic film structure 30 to eliminate the potential difference. Accordingly, a measured current value of the magnetic film structure 30 is zero at the offset voltage. Since the potential difference between the lower magnetic film 42 and the first ferromagnetic film 46 is eliminated when the offset voltage is applied, the electrochemical potential difference can be directly measured by measuring the offset voltage, considering that the potential difference is caused by the electrochemical potential difference between the lower magnetic film 42 and the first ferromagnetic film 46.

Further, since the potential difference exists within the magnetic film structure 30, charges can be extracted from the magnetic film structure 30. Accordingly, the magnetic film structure 30 may be used as a power source.

The potential difference existing within the magnetic film structure 30 is caused by opposite magnetization directions of the lower magnetic film 42 and the first ferromagnetic film 46. Also, since the magnetic field can be applied from the external to determine the magnetization direction of the lower magnetic film 42, the magnetic film structure 30 can be integrated and used as a rechargeable power source, that is, as a secondary cell. In case where the magnetic film structure 30 is used as the power source, an integrated unit having a plurality of magnetic film structures 30 serially connected with one another can be used as the power source. Further, the integrated unit can be also connected in parallel and constructed as the power source.

Alternatively, in case where the magnetic film structure 30 is used as the power source, the magnetization direction of the lower magnetic film 42 can be exchanged by an external magnetic field. Therefore, after the magnetic film structure 30 is charged, that is, after the magnetic field is applied to the lower magnetic film 42 to allow the lower magnetic film 42 to have the opposite magnetization direction to the first ferromagnetic film 46, a magnetic field shielding unit (not shown) may be provided at an external and/or internal of the magnetic film structure 30 such that a magnetization state of the lower magnetic film 42 is not influenced by the external magnetic field. The magnetic field shielding unit may be removed to recharge the magnetic film structure 30.

Next, a physical characteristic of the magnetic film structure 30 shown in FIG. 1 is described with reference to the attached drawings.

FIG. 2 is a graph illustrating a variation of a resistance and a Magneto-Resistance (MR) ratio of the magnetic film structure when a bias voltage from -0.6V to +0.6V is applied to the magnetic film structure of FIG. 1.

In FIG. 2, a first graph (G1) represents the resistance variation of the magnetic film structure of FIG. 1 when the lower magnetic film 42 has the opposite magnetization direction to the first ferromagnetic film 46. Additionally, a second graph (G2) represents the resistance variation of the magnetic film structure of FIG. 1 when the lower magnetic film 42 of the magnetic film structure 30 has the same magnetization direction as the first ferromagnetic film 46. Further, a third graph (G3) represents the variation of the magneto-resistance ratio of the magnetic film structure of FIG. 1.

Referring to the first to third graphs (G1, G2 and G3), the resistance and the magneto-resistance ratio of the magnetic film structure of FIG. 1 are greatly varied at about zero voltage.

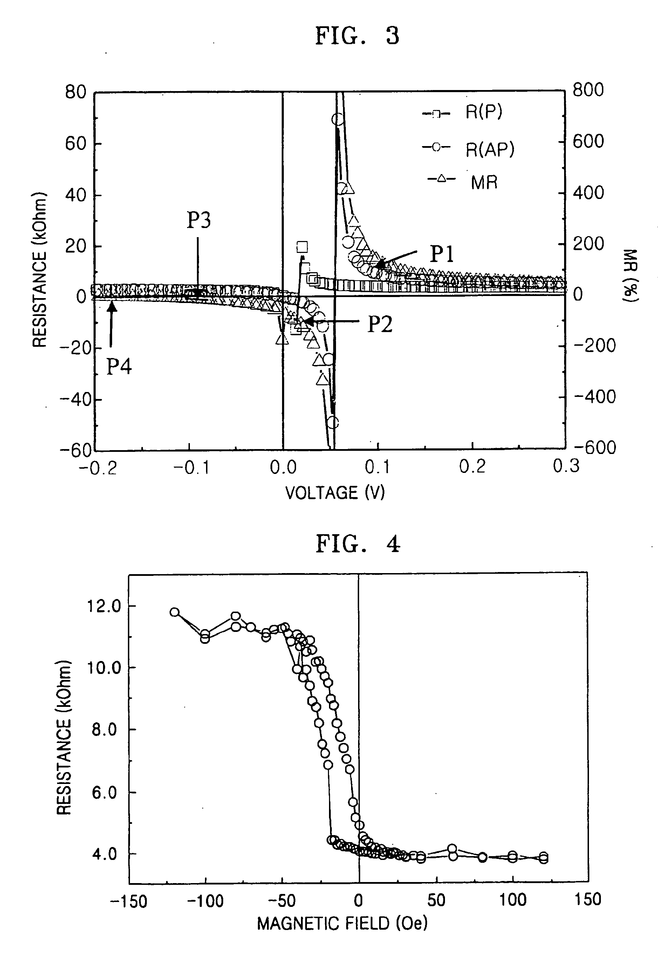

FIG. 3 shows in more detail that the resistance and the magneto-resistance ratio of the magnetic film structure of FIG. 1 greatly vary at about zero voltage.

FIG. 3 is a graph illustrating the resistance variation of the magnetic film structure of FIG. 1 at a bias voltage (-0.2mV to +0.3mV) at which the resistance and the magneto-resistance ratio are asymmetric.

In FIG. 3, a reference symbol "□ " represents a variation of a resistance (hereinafter, referred to as "first resistance") when the lower magnetic film 42 of the magnetic film structure of FIG. 1 has the same magnetization direction as the first ferromagnetic film 46, and a reference symbol "o " represents a variation of a resistance (hereinafter, referred to as "second resistance") when the lower magnetic film 42 has the opposite magnetization direction to the first ferromagnetic film 46. Further, a reference symbol "Δ " represents a variation of the magneto-resistance ratio.

Referring to FIG. 3, the first and second resistances and the magneto-resistance ratio have a changechange in variation at the bias voltage between 0mV and 0.1 mV (100μV).

In detail, until the bias voltage reaches 0.1 mV (100μV), the first and second resistances and the magneto-resistance ratio of the inventive magnetic film structure slowly increase. Then, the second resistance and the magneto-resistance ratio begin to greatly increase as the bias voltage goes over 0.1mV. Even at this time, the first resistance of the magnetic film structure 30 does not vary greatly. As the bias voltage almost reaches 0.050mV (50μV), the second resistance and the magne-

to-resistance ratio of the magnetic film structure 30 rapidly increase, thereby going beyond a graph of FIG. 3. Even at this time, the first resistance of the magnetic film structure 30 does not vary greatly. The first resistance of the magnetic film structure 30 varies rapidly at about 0mV. However, a variation change of the first resistance is much less than a variation change of the second resistance. As the bias voltage applied to the magnetic film structure 30 of FIG. 1 almost reaches 0.050mV (50μV), the second resistance of the magnetic film structure 30 suddenly gets less than zero (0), and reaches a large negative value. Even in case where the second resistance has the variation change, the first resistance does not greatly and also does not have the variation change. As the bias voltage applied to the magnetic film structure 30 continues to approach 0mV, the second resistance rapidly increases to zero. At the bias voltage at which the second resistance reaches from a large negative value to zero (0), the first resistance has the variation change. However, as mentioned above, the variation change of the first resistance is not large when compared to the variation change of the second resistance. Accordingly, when the variation change of the second resistance is compared with the variation change of the first resistance, the variation change of the first resistance is also neglectable. When the first resistance has the variation change, the first resistance becomes negative for a short time, and then when the bias voltage is 0mV, the first resistance again becomes zero (0). After that, when the bias voltage becomes negative, the first resistance becomes again positive. When the bias voltage is 0mV, even the second resistance becomes zero (0), and then when the bias voltage is negative, the second resistance has a positive value, a little larger than zero (0). This state is maintained even though the bias voltage decreases more. The variation of the magneto-resistance (MR) ratio of the magnetic film structure 30 is not greatly different from the variation of the second resistance.

The magnetic film structure 30 has the variation change of the second resistance when the second resistance rapidly increases at the bias voltage between 0mV and 0.1 mV, but does not have the variation change of the first resistance comparable to the variation change of the second resistance. Accordingly, the magneto-resistance ratio of the magnetic film structure 30 is at least 200% at the bias voltage between 0mV and 0.1mV as shown in FIG. 3. Specifically, the magneto-resistance ratio has a large value getting away from a measurement range at the bias voltage at which the second resistance has the variation change. The potential difference between the lower magnetic film 42 and the first ferromagnetic film 46 causes the magnetic film structure 30 to have a large magneto-resistance ratio.

Since the magnetic film structure 30 can have a sufficient magneto-resistance ratio below 0.3mV, a semiconductor device having the magnetic film structure 30 has reduced power consumption.

FIG. 4 is a graph illustrating a resistance variation depending on a magnetic field of the magnetic film structure 30 at a first point (P1) of FIG. 3. At the first point (P1), the bias voltage is about 0.088mV (88μV), and the magneto-resistance ratio is about 197%.

FIG. 5 is a graph illustrating a resistance variation depending on a magnetic field of the magnetic film structure 30 at a second point (P2) of FIG. 3. At the second point (P2), the bias voltage is about 0.016mV (16μV), and the magneto-resistance ratio is about -41%.

FIG. 6 is a graph illustrating a resistance variation depending on a magnetic field of the magnetic film structure 30 at a third point (P3) of FIG. 3. At the third point (P3), the bias voltage is about -0.089mV (-89μV), and the magneto-resistance ratio is about -10%.

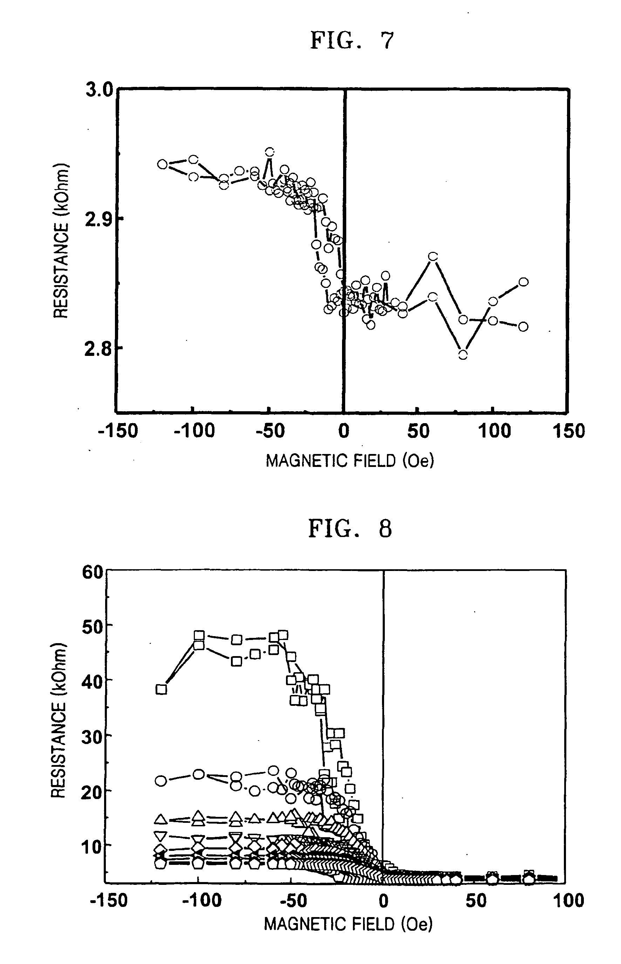

FIG. 7 is a graph illustrating a resistance variation depending on a magnetic field of the magnetic film structure 30 at a fourth point (P4) of FIG. 3. At the fourth point (P4), the bias voltage is about -0.171 mV (-171 μV), and the magneto-resistance ratio is about -2%.

In Table 1 below, the magneto-resistance ratio of the magnetic film structure 30 is summarized for several bias voltages applied to the magnetic film structure 30 with reference to FIG. 3.

Table 1

| Bias voltage (μV) | Magneto-resistance ratio (%) |
|---|---|
| 64 | 760 |
| 70 | 380 |
| 76 | 240 |
| 88 | 170 |
| 98 | 130 |
| 106 | 110 |
| 117 | 94 |
| 126 | 85 |
| 137 | 78 |

FIG. 8 is a graph illustrating a resistance variation of the magnetic film structure 30 depending on an external magnetic field when the plurality of bias voltages of Table 1 are respectively applied.

In FIG. 8, a reference symbol "□ " denotes the resistance variation of the magnetic film structure 30 depending on the external magnetic field when a bias voltage of 64μV is applied to the magnetic film structure 30, and a reference symbol "o " denotes a resistance variation of the magnetic film structure 30 depending on the external magnetic field when a bias voltage of 70μV is applied to the magnetic film structure 30. A reference symbol "Δ " denotes a resistance variation of the magnetic film structure 30 depending on the external magnetic field when a bias voltage of 76μV is applied to the magnetic film structure 30. Further, a reference symbol "∇ " denotes a resistance variation of the magnetic film structure 30 depending on the external magnetic field when a bias voltage of 88μV is applied to the magnetic film structure 30, and a reference symbol "◇ " denotes a resistance variation of the magnetic film structure 30 depending on the external magnetic field when a bias voltage of 98μV is applied to the magnetic film structure 30, and a reference symbol "◄ " denotes a resistance variation of the magnetic film structure 30 depending on the external magnetic field when a bias voltage of 106μV is applied to the magnetic film structure 30. Furthermore, a reference symbol "▷ "denotes a resistance variation of the magnetic film structure 30 depending on the external magnetic field when a bias voltage of 117μV is applied to the magnetic film structure 30, a black hexagon denotes a resistance variation of the magnetic film structure 30 depending on the external magnetic field when a bias voltage of 126μV is applied to the magnetic film structure 30, and a reference symbol of a pentagon denotes a resistance variation of the magnetic film structure 30 depending on the external magnetic field when a bias voltage of 137μV is applied to the magnetic film structure 30.

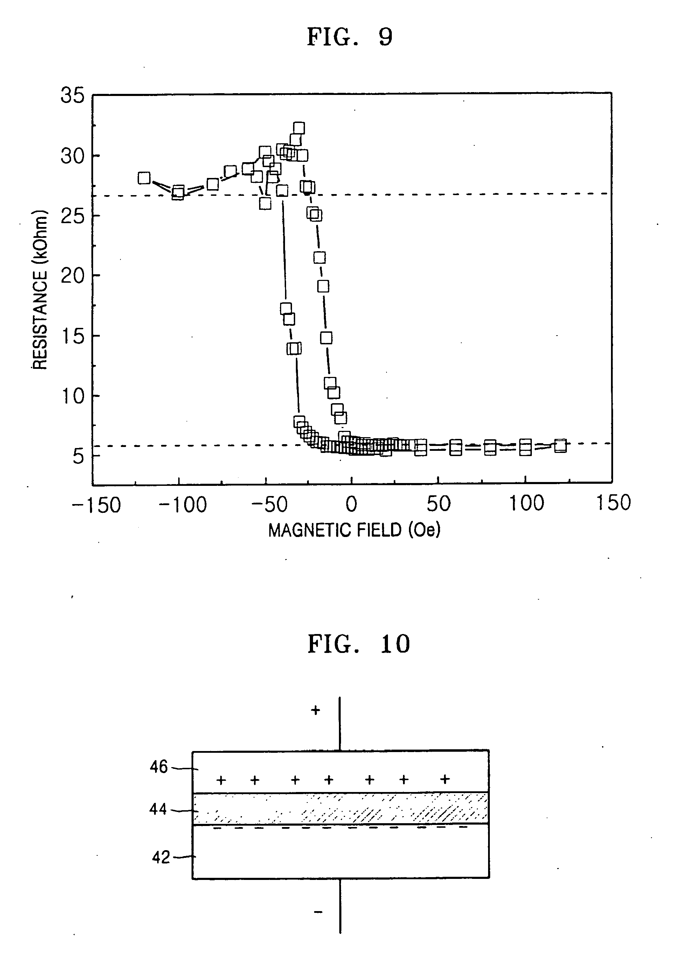

FIG. 9 is a graph illustrating a resistance variation depending on the magnetic field of the magnetic film structure 30 having a magneto-resistance ratio of about ~360% at a bias voltage of 55μV.

Referring to FIG. 9, when the magnetic field is more than zero, the magnetic film structure 30 has the lowest resistance. When the magnetic field is less than zero, the resistance of the magnetic film structure 30 rapidly increases to be as large as at least six times the lowest resistance.

Meanwhile, there are two methods for applying the bias voltage to the magnetic film structure 30.

In a first method, the bias voltage is applied to the magnetic film structure 30 such that a current flows from the first ferromagnetic film 46 to the lower magnetic film 42 (actually, electrons flow from the lower magnetic film 42 to the first ferromagnetic film 46 as shown in FIG. 10).

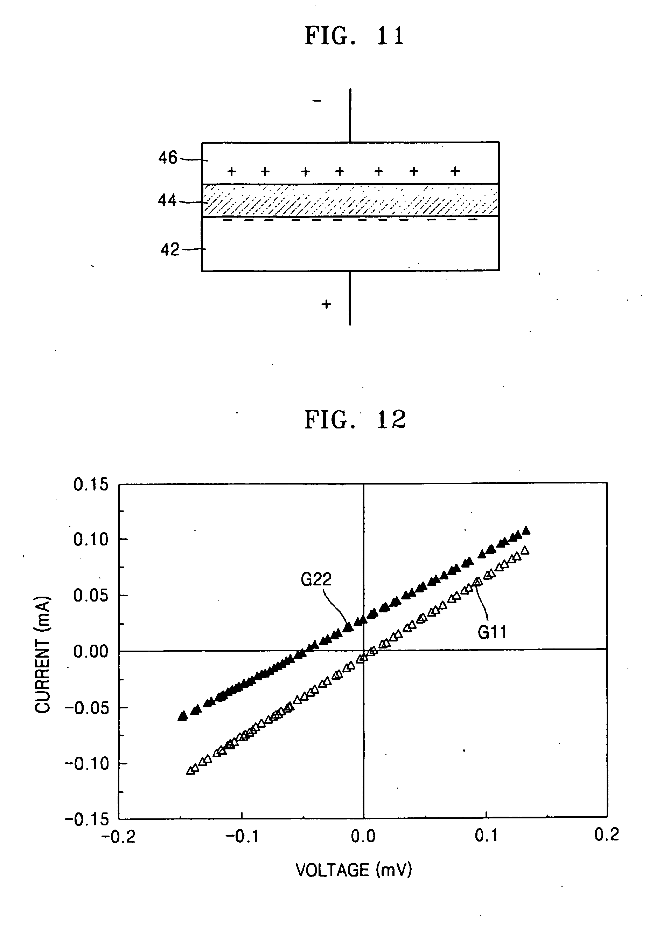

A second method is performed oppositely to the first method as shown in FIG. 11.

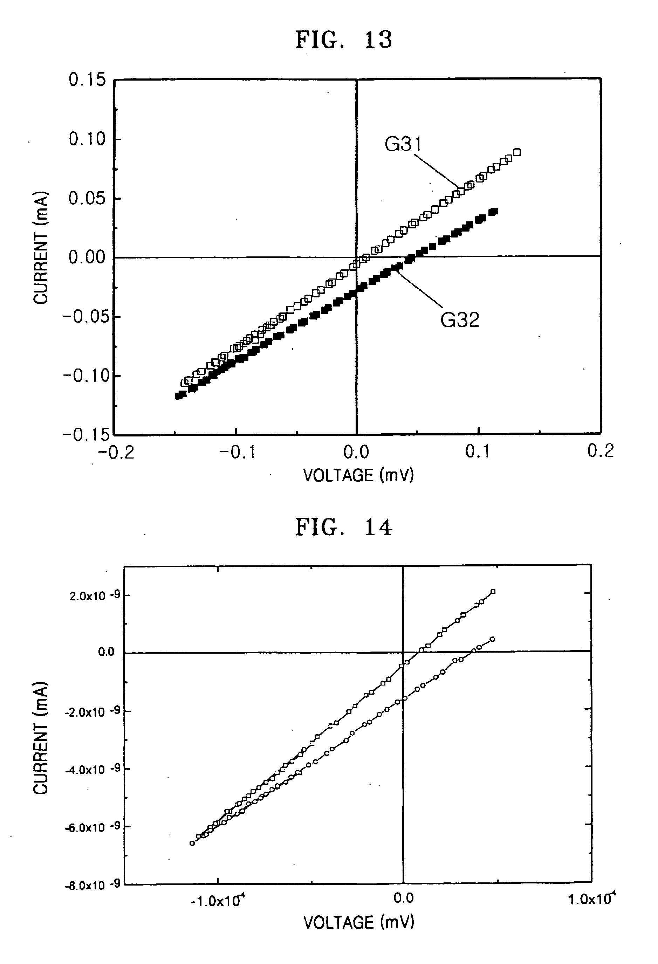

FIGS. 12 and 13 show current-voltage characteristics of the magnetic film structure 30.

FIG. 12 is a graph illustrating a current-voltage characteristic of the magnetic film structure 30 to which the bias voltage is applied according to the first method, and FIG. 13 is a graph illustrating a current-voltage characteristic of the magnetic film structure 30 to which the bias voltage is applied according to the second method.

In FIG. 12, a first graph (G11) illustrates the current-voltage characteristic measured when the lower magnetic film 42 and the first ferromagnetic film 46 of the magnetic film structure 30 have the same magnetization direction. Additionally, a second graph (G22) illustrates the current-voltage characteristic measured when the lower magnetic film 42 and the first ferromagnetic film 46 have opposite magnetization directions to each other.

Referring to the first and second graphs (G11 and G22), in case where the lower magnetization film 42 and the first ferromagnetic film 46 have the same magnetization direction (hereinafter, referred to as "the first case"), when the bias voltage is zero, the current is also zero. However, in case where the lower magnetization film 42 and the first ferromagnetic film 46 have the opposite magnetization directions to each other (hereinafter, referred to as "the second case"), when the bias voltage is zero, the current is not zero. In the second case, when the bias voltage is -0.50mV, the current becomes zero. In other words, the bias voltage at which the current is zero in the second case is shifted to the left by about -0.050mV.

A material characteristic of the magnetic film structure 30 can be varied depending on material constituting the magnetic film structure 30, a size of the magnetic film structure 30, or a temperature of the magnetic film structure 30. Therefore, a shift degree of the bias voltage in the second case can be varied depending on the material constituting the lower magnetic film 42 and/or the first ferromagnetic film 46, and depending on the size and/or temperature of the films 42 and 46. This fact is shown in FIG. 13 illustrating a case in which the bias voltage at which the current becomes zero is shifted to the right.

A first graph (G31) of FIG. 13 shows a current-voltage characteristic in the first case, and is the same as the first graph (G11) of FIG. 12. A second graph (G32) of FIG. 13 shows a current-voltage characteristic in the second case.

Referring to the second graph (G32) of FIG. 13, when the magnetic film structure 30 is in the second case and the bias voltage is applied to the magnetic film structure 30 as shown in FIG. 10, the current becomes zero at the bias voltage of 0.050mV(50µV), not 0mV, for example. In other words, the bias voltage at which the current becomes zero is shifted to the right.

As a result, when the magnetic film structure 30 is in the second case, the bias voltage at which the current becomes zero is shifted, though being applied using any method, just only with the bias voltage having a different shift direction.

The shift of the bias voltage at which the current becomes zero when the magnetic film structure 30 is in the second case is generated due to the potential difference caused by the electrochemical potential between the lower magnetic film 42 and the first ferromagnetic film 46 of the magnetic film structure 30. In other words, even though the bias voltage of 0mV is applied to the magnetic film structure 30 in case where the potential difference exists between the lower magnetic film 42 and the first ferromagnetic film 46, the current of the magnetic film structure 30 does not become zero and the current based on the potential difference is measured from the magnetic film structure 30.

However, as the bias voltage (hereinafter, referred to as "the shift voltage") having a magnitude corresponding to the potential difference is applied to the magnetic film structure 30, the charges are eliminated from the interface of the lower magnetic film 42 and the first ferromagnetic film 46 such that the potential difference does not exist between the lower magnetic film 42 and the first ferromagnetic film 46. In other words, since the shift voltage and the potential difference are offset with each other, the current measured from the magnetic film structure 30 is zero at the shift voltage.

The potential difference between the lower magnetic film 42 and the first ferromagnetic film 46 is eliminated at the shift voltage, thereby allowing the current of the magnetic film structure 30 to become zero as described above. Therefore, the shift voltage just becomes the offset voltage.

The offset voltage of the magnetic film structure 30 is defined as a difference of the bias voltage at which the current becomes zero when the magnetic film structure 30 is in the first case and the bias voltage at which the current becomes zero when the magnetic film structure 30 is in the second case, that is, the shift voltage. However, the offset voltage can be regarded as 0mV since the bias voltage at which the current becomes zero is very close to 0mV when the magnetic film structure 30 is in the first case as shown in FIGS. 12 and 13. Accordingly, the shift voltage can be regarded as the offset voltage of the magnetic film structure 30.

The potential difference existing between the lower magnetic film 42 and the first ferromagnetic film 46 of the magnetic film structure 30 is caused by the electrochemical potential difference between the lower magnetic film 42 and the first ferromagnetic film 46. Accordingly, the measurement of the offset voltage is just like the direct measurement of the electrochemical potential difference between the lower magnetic film 42 and the first ferromagnetic film 46.

Since the current is zero at the offset voltage, the resistance is infinite according to the equation R = V / I. Accordingly, when the magnetic film structure 30 is in the second case, the bias voltage is close to the offset voltage while the resistance and the magneto-resistance ratio of the magnetic film structure 30 respectively have the variation change (Referring to FIG. 3).

The offset voltage of the magnetic film structure 30 varies with a size of the magnetic film structure 30.

In detail, as the size of the magnetic film structure 30 is increased, the offset voltage is decreased. If the size is more than a predetermined value, the voltage shift is not shown in the graph of the current-voltage characteristic of the magnetic film structure 30. This means that when the voltage shift is not generated, the offset voltage is zero.

The above fact can be confirmed in FIGS. 14 to 17.

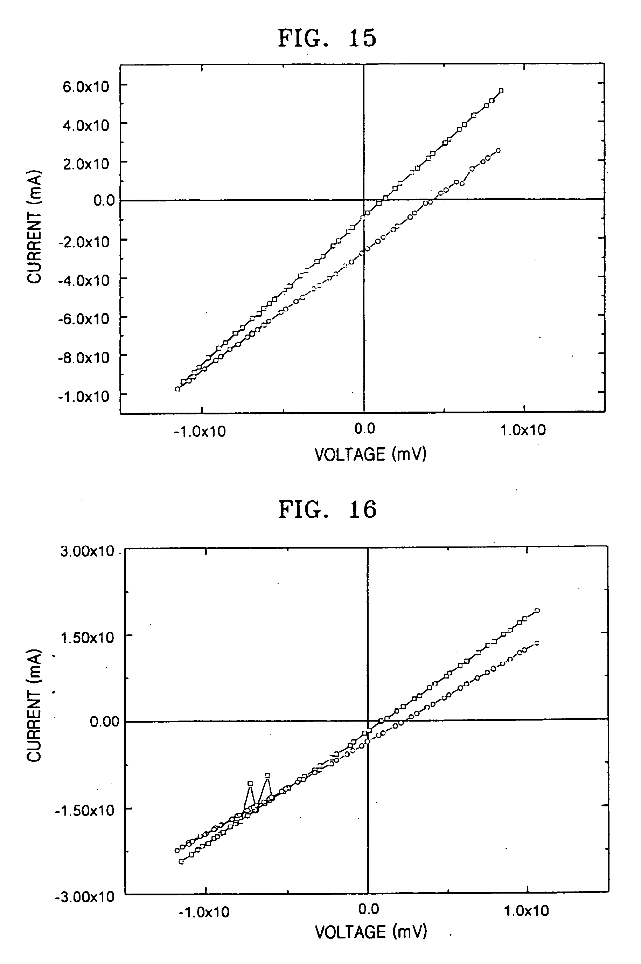

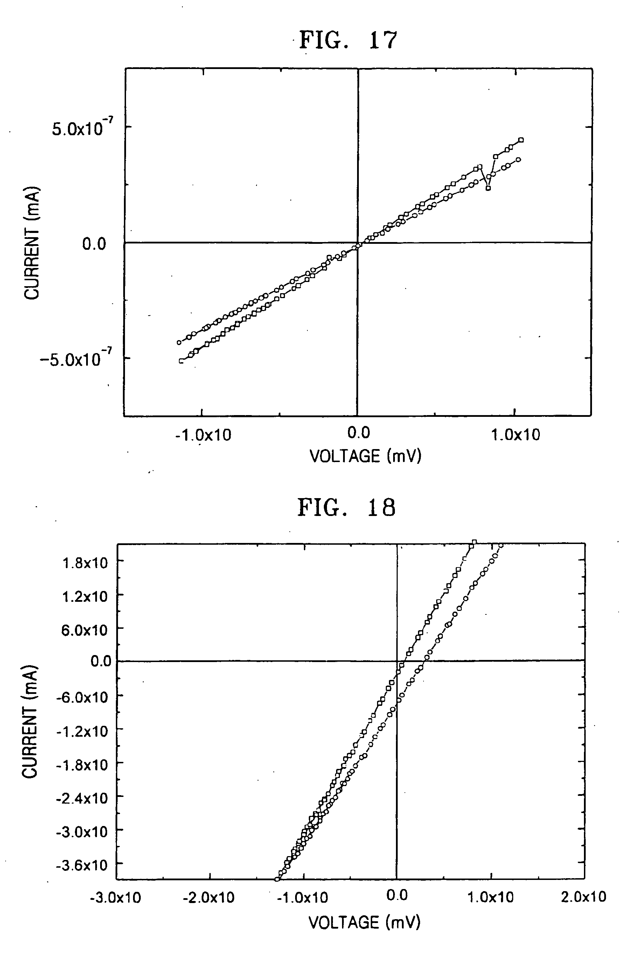

FIGS. 14 to 17 illustrate results respectively measured when the lower magnetic film 42 of the magnetic film structure 30 is formed under the second condition (20mTorr, 600°C) and the magnetic film structure 30 has the sizes of $10\mu m \times 10\mu m$ (FIG. 14), $30\mu m \times 30\mu m$ (FIG. 15), $50\mu m \times 50\mu m$ (FIG. 16), and $100\mu m \times 100\mu m$ (FIG. 17).

In FIGS. 14 to 17, a reference symbol "□" denotes a current-voltage characteristic measured when the magnetic film structure 30 is in the first case, and a reference symbol "o " denotes a current-voltage characteristic measured when the magnetic film structure 30 is in the second case.

Referring to FIGS. 14 to 17, when the magnetic film structure 30 has the sizes of $10\mu m \times 10\mu m$ and $30\mu m \times 30\mu m$, the offset voltage is approximately $27\mu V$. However, when the magnetic film structure 30 has the size of $50\mu m \times 50\mu m$, the offset voltage gets small to about $14\mu V$ as shown in FIG. 16. Additionally, when the magnetic film structure 30 has the size of $100\mu m \times 100\mu m$, the offset voltage becomes $0\mu V$ as shown in FIG. 17.

Alternatively, in case where a resistor is connected to the magnetic film structure 30 of FIG. 1, a current-voltage characteristic of the magnetic film structure 30 is shown in FIG. 18.

Referring to FIG. 18, even in case where the resistor is connected to the magnetic film structure 30, the offset voltage is generated, though being smaller than when the resistor is not connected.

Next, a temperature dependency of the offset voltage is described.

The following Equation 1 is theoretically obtained from the offset voltage and the temperature of the magnetic film structure 30 shown in FIG. 1.

## Equation 1

$$Vd = (8.4 \times 10^{-5})\eta^{2}(Ie/A)C^{1/2}(1/T^{1/4})$$

where

Ie:     electron current

$\eta$ :     spin deflection current

A:     cross section

C:     current degree.

In Equation 1, the offset voltage (Vd) is proportional to the square of 1/4 of an absolute temperature (T).

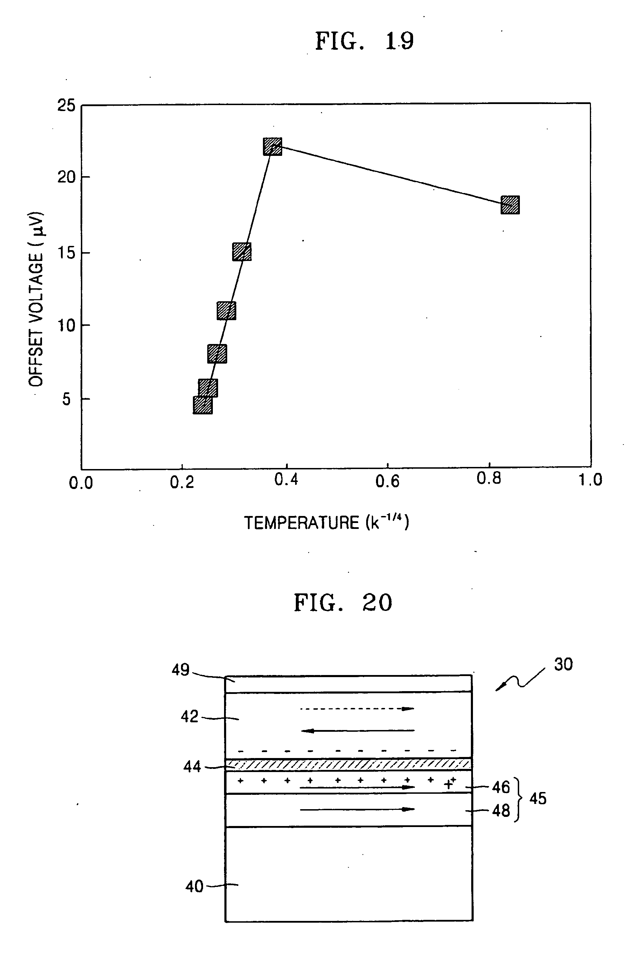

In order to verify whether or not the temperature dependency of the magnetic film structure 30 actually satisfies Equation 1, the offset voltage for the magnetic film structure 30 is measured at a temperature of 50K to 300K at which phonon scattering is dominant. The measurement result is illustrated in FIG. 19.

Referring to FIG. 19, when the temperature (T) is at a range of 50K to 300K, the offset voltage is proportional to $T^{-1/4}$. However, it is not so at 5K at which a residual resistance effect is dominant.

In FIG. 19, a theoretical result and an experimental result for the temperature dependency of the offset voltage are consistent with each other when the temperature (T) of the magnetic film structure 30 is a range of at least 50K to 300K.

In the magnetic film structure 30 of FIG. 1 having the above-described physical characteristic, positions of the half-metal ferromagnetic film 42 and the upper magnetic film 45 may be reversed. For example, as shown in FIG. 20, the half-metal ferromagnetic film 42 is provided on the tunneling film 44, and the upper magnetic film 45 can be provided under the tunneling film 44. At this time, the first ferromagnetic film 46 of the upper magnetic film 45 is in contact with the tunneling film 44, and the second ferromagnetic film 48 is positioned under the first ferromagnetic film 46.

Next, a manufacturing method of the magnetic film structure 30 of FIG. 1 is described.

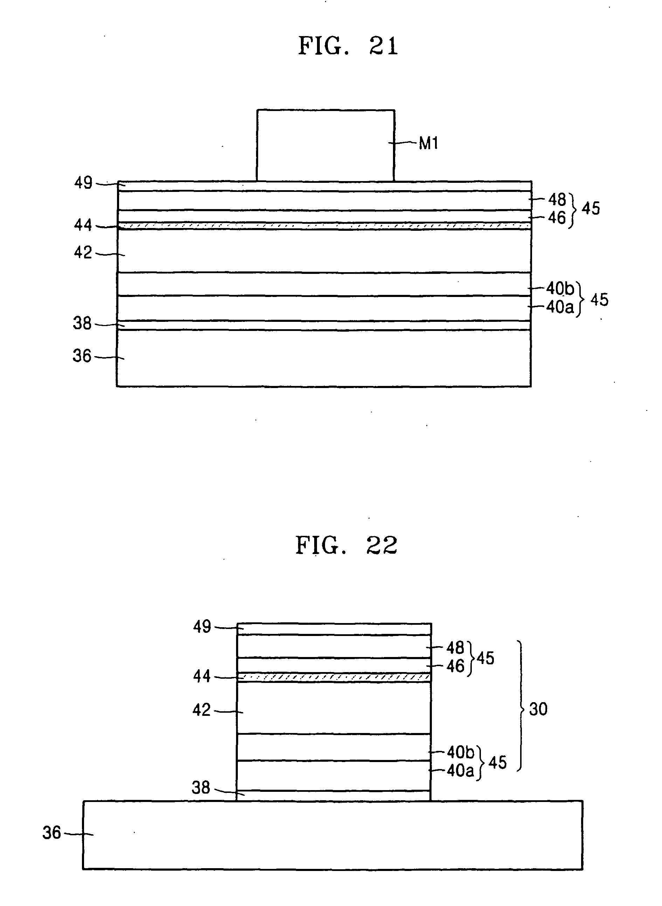

Referring to FIG. 21, a thin insulating film 38 is formed on a substrate 36, for example, on a silicon substrate. The insulating film 38 can be formed of oxide or nonoxide. When the substrate 36 is the silicon substrate, the insulating film 38 may be formed of silicon oxide, but if necessary, it can be formed of other oxides. The silicon oxide film is grown using a thermal growth method. The seed layer 40 is formed on the insulating film 38. The seed layer 40 helps the growth of the lower magnetic film 42, and more smoothens a surface of the half-metal ferromagnetic film 42 to form the tunneling film 44 at a regular thickness.

The lower magnetic film 42 may be formed of a predetermined compound ferromagnetic material, for example, Half-metal Ferromagnetic (HMF) material. In the description of this manufacturing method, the lower magnetic film 42 is described as the half-metal ferromagnetic film 42.

In case where the magnetic film structure 30 of FIG. 1 is used as a magnetic tunnel junction layer of a Magnetic Random Access Memory (MRAM), the half-metal ferromagnetic film 42 is used as a free layer in which a magnetization direction, that is, a spin polarization, is changed by the external magnetic field.

Next, the seed layer 40 may be formed using a sputtering method, but can be also formed using other depositing methods. The seed layer 40 can be formed by sequentially depositing first and second seed layers 40a and 40b. The seed layer 40 can be formed as a magnetic layer, a nonmagnetic layer, or a combination of the magnetic layer and the nonmagnetic layer. In case where the seed layer 40 is formed as the nonmagnetic layer, the first and second seed layers 40a and 40b can be respectively formed of tantalum (Ta) and ruthenium (Ru), for example. In this case, the first seed layer 40a can be formed to have a thickness of 42nm, for example, and the second seed layer 40b can be formed to have a thickness of 9.5nm, for example. In case where the first and second seed layers 40a and 40b are formed using other material layers, the first and second seed layer 40a and 40b can have different thicknesses from the above-described thicknesses.

After the seed layer 40 is formed as described above, the half-metal ferromagnetic film 42 is deposited on the seed layer 40. The half-metal ferromagnetic film 42 is the lower magnetic film. The half-metal ferromagnetic film 42 can be formed of $Co_2MnSi$, for example. The $Co_2MnSi$ is a Heusler alloy, and is found to be a half-metal ferromagnetic film in a calculation of a band structure. In case where the half-metal ferromagnetic film 42 is a $Co_2MnSi$ film, the half-metal ferromagnetic film 42 can be formed to have a predetermined thickness, for example, 47nm. In case where the half-metal ferromagnetic film 42 is formed of other material films than the $Co_2MnSi$ film, the half-metal ferromagnetic film 42 can have a different thickness. In order to form the half-metal ferromagnetic film 42 with an excellent crystallinity, the substrate 36 can be formed at a predetermined temperature, for example, at above 500°C, or may be formed at 500°C to 600°C. The half-metal ferromagnetic film 42 may be formed at a low pressure, for example, at $5 \times 10^{-8}$ torr. The half-metal ferromagnetic film 42 can be formed using a deposition equipment, for example, a sputtering equipment for maintaining the above-described temperature and pressure condition during deposition.

Meantime, in case where the seed layer 40 and the half-metal ferromagnetic film 42 are all formed using the sputtering method, the seed layer 40 and the half-metal ferromagnetic film 42 can be formed in situ using the same sputtering equipment.

Further, the half-metal ferromagnetic film 42 can be reduced in surface roughness by controlling its relating variables, for example, a Radio Frequency (RF) power or a pressure. By doing so, the tunneling film 44 can be formed at a regular thickness on the half-metal ferromagnetic film 42.

After the half-metal ferromagnetic film 42 is formed as described above, the tunneling film 44 is formed on the half-metal ferromagnetic film 42. The tunneling film 44 can be formed of oxide, for example, aluminum oxide such as alumina ($Al_2O_3$), and can be also formed of nonoxide. In case where the tunneling film 44 is formed of aluminum oxide, the tunneling film 44 can be formed at a thickness of about 1.5nm. However, in case where the tunneling film 44 is formed of oxides other than aluminum oxide or nonoxide, the tunneling film 44 can be formed at a different thickness.

Further, in case where the tunneling film 44 is formed of aluminum oxide, the tunneling film 44 can be formed using the sputtering equipment in the same manner as the seed layer 40 and the half-metal ferromagnetic film 42.

In detail, after the half-metal ferromagnetic film 42 is formed using the sputtering equipment, the sputtering equipment is cooled to a room temperature. After that, the aluminum film is deposited at a predetermined thickness on the half-metal ferromagnetic film 42 in the cooled sputtering equipment. After that, the deposited aluminum film is oxidized using a plasma oxidation process to form the aluminum oxide film on the half-metal ferromagnetic film 42. The plasma oxidation process may be performed in the sputtering equipment, but it does not matter that the plasma oxidation process is performed using other equipments. In case where the plasma oxidation process is performed using the sputtering equipment, the sputtering equipment is maintained at an atmosphere of pure oxygen and a pressure of 150mTorr until the plasma oxidation process is completed.

After the tunneling film 44 is formed as described above, the upper magnetic film 45 is formed on the tunneling film 44. The upper magnetic film 45 can be formed using the sputtering equipment, but other deposition equipments can be used. The upper magnetic film 45 is formed by sequentially depositing first and second ferromagnetic films 46 and 48. The first ferromagnetic film 46 has the magnetization direction in a given direction by the second ferromagnetic film 48. The first ferromagnetic film 46 can be formed of CoFe, but can be also formed of other ferromagnetic materials. The first ferromagnetic film 46 can have a different thickness depending on its forming material. For example, in case where the first ferromagnetic film 46 is formed of cobalt iron, the first ferromagnetic film 46 can be formed at a thickness of 7.5nm. However, in case where the first ferromagnetic film 46 is formed of other materials, it can be formed thicker or thinner. The second ferromagnetic film 48 is a pinning film for establishing the magnetization direction of the first ferromagnetic film 46. The second ferromagnetic film 48 can be formed as a single film or a multi film. In case where the second ferromagnetic film 48 is formed as the single film, it can be formed to have a predetermined thickness by using an Anti Ferromagnetic Film (AFM), for example, to have a thickness of 15.5nm by using an iridium manganese (IrMn) film. In case where the second ferromagnetic film 48 is formed as the multi film, the second ferromagnetic film 48 can be formed using a Synthetic Anti-Ferromagnetic (SAF) film having a conductive film and a magnetic film provided on and under the conductive film. The magnetization direction of the first ferromagnetic film 46 is established by an exchange bias effect or an interlayer coupling through the SAF film.

As described above, after the upper magnetic film 45 is formed, the capping layer 49 is formed on the upper magnetic film 45 to prevent the oxidation of the upper magnetic film 45, especially, the oxidation of the second ferromagnetic film 48. The capping layer 49 may be formed using the sputtering equipment, which is maintained at the room temperature, but can be formed using other deposition equipments. In case where the capping layer 49 is formed using the sputtering equipment, the capping layer 49 can be formed in situ after the upper magnetic film 45 is formed. The capping layer 49 can be formed of ruthenium (Ru) at a thickness of 60nm, for example. However, the capping layer 49 can also have a different thickness when it is formed of a different material.

Next, a photosensitive film pattern (M1) is formed on the capping layer 49 to define a predetermined region of the capping layer 49. The defined region of the capping layer 49 may have a size of $10\mu m \times 10\mu m$, but can be extended up to a size for allowing the observation of the offset voltage. For example, the defined region can be extended to have a size of $30\mu m \times 30\mu m$, $50\mu m \times 50\mu m$ or more. Further, if the offset voltage can be observed, the defined region does not necessarily have a square shape. Accordingly, the defined region can have different vertical and horizontal lengths.

After that, the photosensitive film pattern (M1) is used as an etching mask to etch the capping layer 49 at a periphery of the photosensitive film pattern (M1). The etching is performed until the substrate 36 is exposed to the outside. Next, the photosensitive film pattern (M1) is eliminated. By doing so, the magnetic film structure 30 of FIG. 1 is formed on the substrate 36 as shown in FIG. 22.

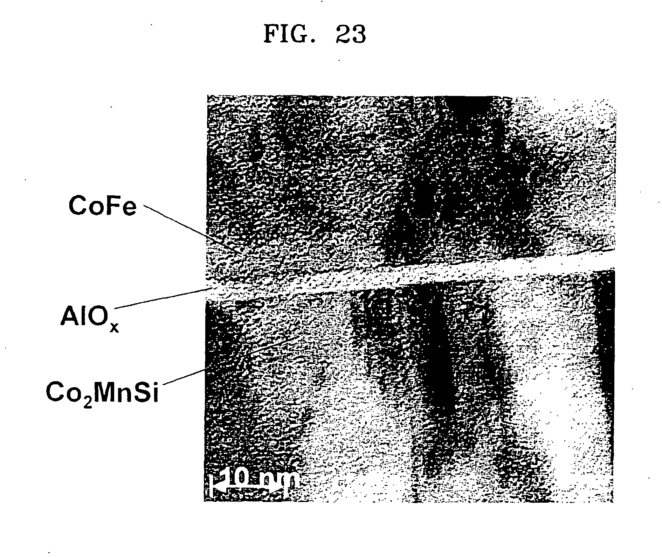

FIG. 23 is a Transmission Electron Microscopy (TEM) illustrating a section of the magnetic film structure 30 formed using the above-described manufacturing method.

Referring to FIG. 23, the tunneling film 44 is formed at a regular thickness.

Next, a semiconductor device having the magnetic film structure 30 of FIG. 1, especially, a semiconductor memory device is described.

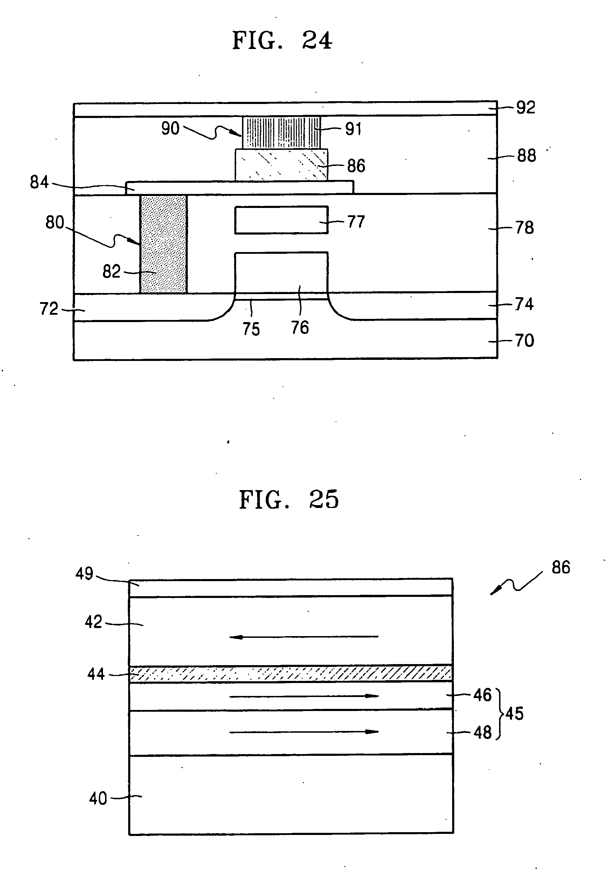

FIG. 24 is a sectional view illustrating the magnetic RAM in which the magnetic film structure 30 of FIG. 1 is used as a Magnetic Tunnel Junction (MTJ) layer.

Ref erring to FIG. 24, the MRAM has first and second impurity regions 72 and 74 formed by doping conductive impurities into a semiconductor substrate 74. A channel region 75 is formed in the semiconductor substrate 70 between the first and second impurity regions 72 and 74. The first impurity region 72 can be a source region or a drain region. The second impurity region 74 can also be a source region or a drain region. A deposited gate material 76 is formed on the channel region 75 between the first and second impurity regions 72 and 74. The deposited gate material 76 can include a gate insulating film (not shown), a gate electrode (not shown), and a gate spacer (not shown). The semiconductor substrate 70, the first and second impurity regions 72 and 74, the channel region 75 and the deposited gate material 76 constitute a Field Effect Transistor (FET). An interlayer insulating layer 78 is formed on the semiconductor substrate 70 to cover the first and second impurity regions 72 and 74 and the deposited gate material 76. A contact hole 80 is provided in the interlayer insulating layer 78 to expose the first impurity region 72 to the external. The contact hole 80 is filled with a conductive plug 82. The conductive plug 82 and the first impurity region 72 may be in ohmic contact with each other to reduce a contact resistance. A pad conductive layer 84 is formed on the interlayer insulating layer 78 to be connected to the conductive plug 82. The pad conductive layer 84 is extended over the deposited gate material 76. A digit line 77 is formed in the interlayer insulating layer 78 between the pad conductive layer 84 and the deposited gate material 76. The digit line 77 is used to generate the magnetic field for recording data in the MTJ layer 86 described later. The MTJ layer 86 is provided on the pad conductive layer 84. The MTJ layer 86 may be provided over the digit line 77. Further, the MTJ layer 86 may be the magnetic film structure 30 of FIG. 1. An interlayer insulating layer 88 is formed on the interlayer insulating layer 78 to cover the MTJ layer 86. A via hole 90 is provided in the interlayer insulating layer 88 to expose the MTJ layer 86 to the outside. The via hole 90 is filled with a conductive plug 91. A bit line 92 is formed on the interlayer insulating layer 88 to be connected to the conductive plug 91. The bit line 92 is used together with the digit line 77 to record data in the MTJ layer 86. In other words, a direction of a current flowing through the bit line 92 and the digit line 77 can be controlled to control the magnetization direction of the half-metal ferromagnetic film (42 of FIG. 1) of the MTJ layer 86.

The above-described MRAM can be formed using a general MRAM manufacturing process. However, the MTJ layer 86 may be formed using a manufacture method of the magnetic film structure 30.

Next, an operation method of the MRAM shown in FIG. 24 is described. At this time, the MTJ layer 86 of the MRAM is assumed to include the half-metal ferromagnetic film 42 provided on the tunneling film 44 as shown in FIG. 20.

<Writing>

Referring to FIG. 24, the current is supplied to the digit line 77 and the bit line 92 in the given direction. At this time, the magnetic field is generated at the digit line 77 and the bit line 92. The magnetic field (hereinafter, referred to as "external magnetic field") causes the spin polarization of the electrons of the half-metal ferromagnetic film 42, which is the free layer of the MTJ layer 86, to be arranged in a direction of the external magnetic field. The result of the arrangement is externally shown so that the half-metal ferromagnetic film 42 is magnetized in the direction of the magnetic field.

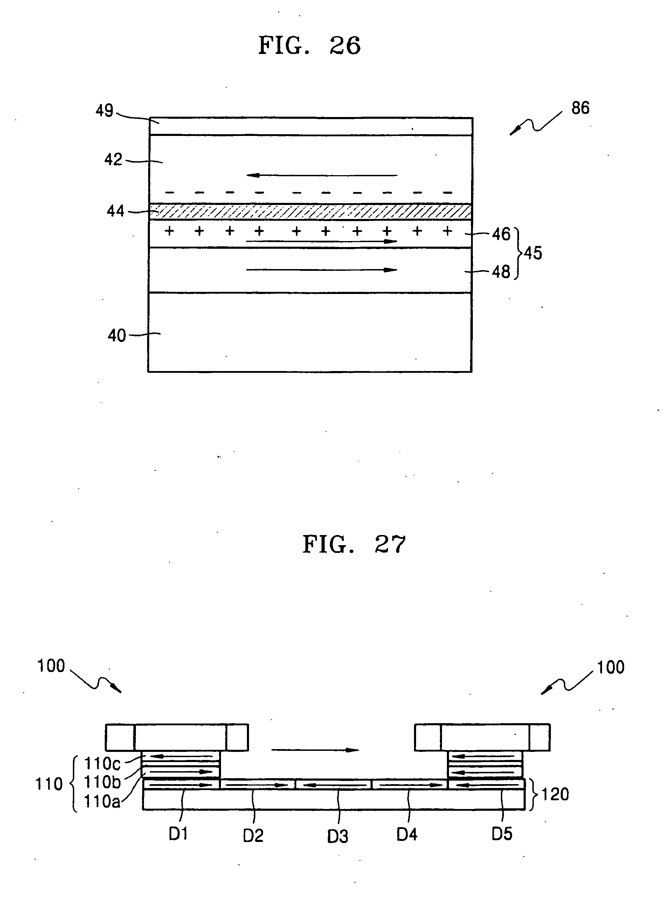

FIG. 25 illustrates a case in which the external magnetic field has the same magnetization direction as the first ferromagnetic film 46, and FIG. 26 illustrates a case in which the external magnetic field has the opposite magnetization direction to the first ferromagnetic film 46.

As shown in FIG. 25, in case where the magnetization direction of the half-metal ferromagnetic film 42 is the same as that of the first ferromagnetic film 46 due to the external magnetic field, data "0" is recorded in the magnetic RAM.

Further, as shown in FIG. 26, in case where the magnetization direction of the half-metal ferromagnetic film 42 is opposite to that of the first ferromagnetic film 46 due to the external magnetic field, data "1" is recorded in the magnetic RAM. Data "0" and "1" can be recorded oppositely.

In case where data "1" is recorded in the magnetic RAM, for the same reason described in the descriptions of the magnetic film structure 30 of FIG. 1, the positive charges (+) are collected at an interface of the first ferromagnetic film 46 contacting with the tunneling film 44, and the negative charges (-) are collected at an interface of the half-metal ferromagnetic film 42 contacting with the tunneling film 44. As a result, in case where data "1" is recorded in the magnetic RAM, the potential difference is formed between the half-metal ferromagnetic film 42 and the first ferromagnetic film 46.

<Reading>

In case where data "0" is recorded in the inventive magnetic RAM in a state shown in FIG. 25, a transistor is turned on, and a resistance of the MTJ layer 86 can be measured to read data "0" recorded in the MTJ layer 86.

In case where data "1" is recorded in the inventive magnetic RAM in a state shown in FIG. 26, data "1" can be read from the MTJ layer 86 through the following three methods.

First, a method of measuring the resistance of the MTJ layer 86 will be presented.

Second, a method according to the invention of measuring the shift voltage, that is, the offset voltage will be described.

Third, a method according to the invention of measuring the current caused by the potential difference between the half-metal ferromagnetic film 42 and the first ferromagnetic film 46 will be explained.

In case where data "1" is read in the third method, the external magnetic field is used to invert the magnetization direction of the half-metal ferromagnetic film 42 into the same direction as the first ferromagnetic film 46. In case where the magnetization direction of the half-metal ferromagnetic film 42 is inverted into the same direction of the first ferromagnetic film 46, the charges collected at the interfaces of the half-metal ferromagnetic film 42 and the first ferromagnetic film 46 contacting with the tunneling film 44 flow through the transistor acting as a switching element. Therefore, the current is sensed using a sensor amplifier connected to the second impurity region 74 of the transistor.

However, after data "1" is read in the third method, the charges are all eliminated at the interfaces of the half-metal ferromagnetic film 42 and the first ferromagnetic film 46 contacting with the tunneling film 44. Therefore, in order to maintain original data "1", the magnetization direction of the half-metal ferromagnetic film 42 is inverted into the opposite magnetization direction to that of the first ferromagnetic film 46 after data "1" is read. This can be accomplished by inverting the direction of the external magnetic field.

<Erasing>

After the transistor is turned off in FIG. 24, the magnetization directions of the half-metal ferromagnetic film 42 and the first ferromagnetic film 46 are allowed to be identical. That is, the magnetization direction of the half-metal ferromagnetic film 42 is inverted to be the same as the magnetization direction of the first ferromagnetic film 46. The magnetization direction of the half-metal ferromagnetic film 42 can be inverted by the magnetic field generated from the bit line 92 and the digit line 77.

The magnetic film structure 30 of FIG. 1 can be also applied to other semiconductor devices.

FIG. 27 illustrates an example of the magnetic film structure 30 of FIG. 1 used as a magnetic sensor 110 of the magnetic head 100.

In FIG. 27, a reference numeral 120 denotes a magnetic recording media, and reference numerals D1 to D5 denote domains of the magnetic recording media 120.

Referring to FIG. 27, in case where the magnetic sensor 110 of the head 100 is in proximal to the magnetic recording media 120 to read data from the magnetic recording media 120, the magnetization direction of the half-metal ferromagnetic film 110a of the magnetic sensor 110 is influenced by the magnetization direction of the first to fifth domains (D1,..., D5) of the magnetic recording media 120. For example, an initial magnetization direction of a half-metal ferromagnetic film 110a of the magnetic sensor 110 and the magnetization direction of a pinning film 110c are left on the drawing, and magnetization directions of the first to fifth domains (D1,..., D5) are right, right, left, right and left, respectively. In this state, in case where the magnetic sensor 110 is moved from the first domain (D1) to the fifth domain (D5), the magnetization direction of the half-metal ferromagnetic film 110a is inverted and right on the first domain (D1). Accordingly, the resistance of the magnetic sensor 110 is increased. The magnetization direction of the half-metal ferromagnetic film 110a is maintained as it is to the right on the second domain (D2), and the magnetization direction of the half-metal ferromagnetic film 110a is again inverted into the left on the third domain (D3). Accordingly, when the half-metal ferromagnetic film 110a is positioned on the third domain (D3), the resistance of the magnetic sensor 110 is lowered. When the magnetic sensor 110 is positioned on the fourth domain (D4), the magnetization direction of the half-metal ferromagnetic film 110a is again inverted into the right to again increase the resistance of the magnetic sensor 110. When the magnetic sensor 110 passes the fourth domain (D4) and is positioned on the fifth domain (D5), the magnetization direction of the half-metal ferromagnetic film 110a is again inverted into the left to lower the resistance of the magnetic sensor 110.

As such, the resistance of the magnetic sensor 110 becomes different depending on the magnetization direction of each domain of the magnetic recording media 120. Therefore, this can be used to read a magnetization state of each domain of the magnetic recording media 120, that is, data recorded in each domain of the magnetic recording media 120.

As described above, in the magnetic film structure 30, the charges are caused by the electrochemical potential difference of the two ferromagnetic film at facing surfaces of the two ferromagnetic films when the magnetization direction, which is changed by the external magnetic field, of the half-metal ferromagnetic film is opposite to the magnetization direction, which is in the given direction, of the ferromagnetic film. Accordingly, the potential difference is formed between the two magnetic films, and the potential difference causes the current-voltage characteristic curve of the magnetic film structure to be shifted by a given value. That is, the offset voltage is observed in the current-voltage characteristic curve. Additionally, the magnetic resistance ratio of the magnetic film structure is rapidly increased at a periphery of the offset voltage.

Accordingly, according to the magnetic film structure 30, a high magnetic resistance ration can be obtained at a low voltage. Therefore, in case where the magnetic film structure 30 is used for a semiconductor memory device, for example, for a magnetic RAM, power consumption can be not only reduced, but also data can be clearly and exactly read due to a high magnetic resistance ratio. Further, as the magnetic film structure has a smaller size, it has an excellent effect. Therefore, a semiconductor device, for example, a logic device having the magnetic film structure 30, can have an increased integration degree and reduced power consumption. Further, the magnetic film structure 30 has its potential difference, and the potential difference can be always provided by changing the magnetization direction of the half-metal ferromagnetic film to be opposite to the magnetization direction of the ferromagnetic film. Therefore, the inventive magnetic film structure 30 can be integrated and used as a rechargeable battery.

While the present invention has been particularly shown and described with reference to exemplary embodiments thereof, it will be understood by those of ordinary skill in the art that various changes in form and details may be made therein without departing from the scope of the present invention as defined by the following claims. For example, those of ordinary skill in the art can apply the magnetic film structure 30 of FIG. 1 or FIG. 20 to a logic device, for example, an inverter and the like. Further, a half-metal ferromagnetic film, which has a semiconductor component, for example, germanium (Ge) other than silicon (Si), can be used. A half-metal ferromagnetic film, which has copper (Cu) instead of cobalt, can be also used.

## Claims

1. A method of operating a semiconductor memory device, the semiconductor memory device having: a substrate; a switching element formed on the substrate; and a data storing unit connected to the switching element, the data storing unit having a lower magnetic film, a tunneling film and an upper magnetic film that are sequentially deposited, the lower and upper magnetic films being ferromagnetic films forming an electrochemical potential difference therebetween when the lower and upper magnetic films have opposite magnetization directions;
   wherein in a state where the switching element is turned off, a magnetic field is applied to the data storing unit in a given direction to record data in the data storing unit;
   **characterised in that** data recorded in the data storing unit is read in a state where the switching element is turned on, by measuring an offset voltage of the data storing unit to read data from the data storing unit.

2. A method of operating a semiconductor memory device further **characterised in that** data recorded in the data storing unit is read by a first process of applying the magnetic field to the data storing unit such that the upper and lower magnetic films have the same magnetization direction in the state where the switching element is turned on, and a second process of sensing whether or not a current of more than a predetermined value flows through the data storing unit.

3. The method of claim 2, wherein in case where the current of more than the predetermined value is sensed, magnetization state of one of the upper and lower magnetic films whose magnetization state is varied through the first process is restored to the original state:

4. The method of claim 3, wherein a magnetic field having an opposite direction to the magnetic field applied in the first process is applied to the magnetic film whose magnetization state is varied through the first process to restore magnetization state of the magnetic film to the original state.

5. The method of any of claims 1 to 4, wherein in the state where the switching element is turned off, the upper and lower magnetic films are allowed to have the same magnetization direction to erase data from the data storing unit.

## Patentansprüche

1. Verfahren zum Betrieb einer Halbleiterspeichervorrichtung, wobei die Halbleiterspeichervorrichtung aufweist:

ein Substrat, ein auf dem Substrat ausgebildetes Schaltelement und eine mit dem Schaltelement verbundene Datenspeichereinheit, wobei die Datenspeichereinheit einen unteren Magnetfilm, einen Tunnelfilm und einen oberen Magnetfilm aufweist, die sequentiell abgeschieden sind, wobei der untere und der obere Magnetfilm ferromagnetische Filme sind, die eine elektrochemische Potentialdifferenz dazwischen ausbilden, wenn der untere und obere Magnetfilm entgegengesetzte Magnetisierungsrichtungen aufweisen,

wobei in einem Zustand, in dem das Schaltelement abgeschaltet ist, ein Magnetfeld an die Datenspeichereinheit in eine vorgegebene Richtung angelegt wird, um Daten in der Datenspeichereinheit aufzuzeichnen, **dadurch gekennzeichnet, dass** in der Datenspeichereinheit aufgezeichnete Daten in einem Zustand gelesen werden, in dem das Schaltelement angeschaltet ist, indem eine Offsetspannung der Datenspeichereinheit gemessen wird, um Daten aus der Datenspeichereinheit zu lesen.

2. Verfahren zum Betrieb einer Halbleiterspeichervorrichtung, ferner **dadurch gekennzeichnet, dass** in der Datenspeichereinheit gespeicherte Daten durch einen ersten Prozess, bei dem das Magnetfeld an die Datenspeichereinheit derart angelegt wird, dass der obere und untere Magnetfilm die gleiche Magnetisierungsrichtung in dem Zustand aufweisen, in dem das Schaltelement angeschaltet ist, und einen zweiten Prozess zum Erfassen, ob ein Strom von mehr als einem vorgegebenen Wert durch die Datenspeichereinheit fließt oder nicht, gelesen werden.

3. Verfahren nach Anspruch 2, wobei im Fall, bei dem der Strom von mehr als dem vorgegebenen Wert erfasst wird, der Magnetisierungszustand des oberen oder des unteren Magnetfilms, dessen Magnetisierungszustand durch den ersten Prozess verändert wurde, in den Ursprungszustand zurückversetzt wird.

4. Verfahren nach Anspruch 3, wobei ein Magnetfeld mit einer zum im ersten Prozess angelegten Magnetfeld entgegengesetzten Richtung an den Magnetfilm angelegt wird, dessen Magnetisierungszustand durch den ersten Prozess verändert wurde, so dass der Magnetisierungszustand des Magnetfilms in den Ursprungszustand zurückversetzt wird.

5. Verfahren nach einem der Ansprüche 1 bis 4, wobei in dem Zustand, in dem das Schaltelement abgeschaltet ist, für den oberen und unteren Magnetfilm die gleiche Magnetisierungsrichtung ermöglicht wird, um Daten aus der Datenspeichereinheit zu löschen.

**Revendications**

1. Procédé de fonctionnement d'un dispositif de mémoire à semi-conducteurs, le dispositif de mémoire à semi-conducteurs comportant : un substrat ; un élément de commutation formé sur le substrat ; et une unité de stockage de données connectée à l'élément de commutation, l'unité de stockage de données comportant un film magnétique inférieur, un film à effet tunnel et un film magnétique supérieur qui sont séquentiellement déposés, les films magnétiques inférieur et supérieur étant des films ferromagnétiques formant une différence de potentiel électrochimique entre eux lorsque les films magnétiques inférieur et supérieur ont des directions de magnétisation opposées ;

dans lequel, dans un état où l'élément de commutation est désactivé, un champ magnétique est appliqué à l'unité de stockage de données dans une direction donnée pour enregistrer des données dans l'unité de stockage de données ;

**caractérisé en ce que** les données enregistrées dans l'unité de stockage de données sont lues dans un état où l'élément de commutation est activé, en mesurant une tension de décalage de l'unité de stockage de données pour lire les données depuis l'unité de stockage de données.

2. Procédé de fonctionnement d'un dispositif de mémoire à semiconducteurs **caractérisé en outre en ce que** les données enregistrées dans l'unité de stockage de données sont lues par un premier processus consistant à appliquer le champ magnétique à l'unité de stockage de données de sorte que les films magnétiques supérieur et inférieur aient la même direction de magnétisation dans l'état où l'élément de commutation est activé, et un second processus consistant à détecter si un courant supérieur à une valeur prédéterminée circule ou non à travers l'unité de stockage de données.

3. Procédé selon la revendication 2, dans lequel, dans un cas où le courant supérieur à la valeur prédéterminée est capté, l'état de magnétisation d'un des films magnétiques supérieur et inférieur dont l'état de magnétisation varie par le biais du premier processus est rétabli dans l'état d'origine.

4. Procédé selon la revendication 3, dans lequel un champ magnétique ayant une direction opposée au champ magnétique appliqué lors du premier processus est appliqué au film magnétique dont l'état de magnétisation varie par le biais du premier processus pour rétablir l'état de magnétisation du film magnétique dans l'état d'origine.

5. Procédé selon l'une quelconque des revendications 1 à 4, dans lequel, dans l'état où l'élément de commutation est désactivé, les films magnétiques supérieur et inférieur peuvent avoir la même direction de magnétisation pour effacer les données de l'unité de stockage de données.

## FIG. 1

## FIG. 2

## FIG. 3

## FIG. 4

## FIG. 5

## FIG. 6

## FIG. 7

## FIG. 8

# FIG. 9

# FIG. 10

# FIG. 11

# FIG. 12

## FIG. 13

## FIG. 14

## FIG. 15

## FIG. 16

## FIG. 17

## FIG. 18

## FIG. 19

## FIG. 20

# FIG. 21

# FIG. 22

FIG. 23

CoFe

AlO$_x$

Co$_2$MnSi

# FIG. 24

# FIG. 25

## FIG. 26

## FIG. 27

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **TEHRANI et al.** Magnetoresistive random access memory using magnetic tunnel junctions. *Processings of the IEEE,* May 2003, vol. 91 (5), 703-714